# EUROPÄISCHE PATENTANMELDUNG

(11) **EP 3 618 020 A1**
(43) Veröffentlichungstag der Anmeldung: **04.03.2020**
(21) Anmeldenummer: 18191609.9
(22) Anmeldetag: 30.08.2018
(51) Int. Cl.: G08C 15/00, H01R 31/06, H04J 7/00, H04L 5/00, F16D 66/00

(54) **KABELADAPTER ZUM SAMMELN UND WEITERLEITEN ANALOGER SIGNALE VON EINER MEHRZAHL VON SENSOREN IN EINEM KRAFTFAHRZEUG, SOWIE VERFAHREN UND VERWENDUNG HIERZU**

(71) Anmelder: WABCO Europe BVBA, 1170 Brüssel (BE)
(72) Erfinder: Gründker, Oliver, 30900 Wedemark (DE); John, Michael, 31275 Lehrte (DE); Müntefering, Dirk, 30900 Wedemark (DE)
(74) Vertreter: Rabe, Dirk-Heinrich

(57) **Zusammenfassung**

Die Erfindung betrifft einen Kabeladapter (1) zum Sammeln und Weiterleiten analoger Signale von einer Mehrzahl von Sensoren (103, 105) in einem Kraftfahrzeug (100), insbesondere Bremsbelagsverschleißsensoren einer Nutzfahrzeugscheibenbremse. Es wird vorgeschlagen, dass der Kabeladapter erste und zweite Signaleingangsanschlüsse (5,7) zum Verbinden des Kabeladapters (1) mit Sensoren (103, 105) und zum Empfang von Signalströmen (20, 22),
einen Signalausgangsanschluss zum Verbinden des Kabeladapters (1) mit einer elektronischen Steuereinheit (113) des Kraftfahrzeugs (100), und eine Schaltelektronik (13) aufweist, die dazu eingerichtet ist, in einem vorbestimmten Rhythmus die ersten und zweiten Signalströme (20,22; 21,23;21',23')), an den Signalausgangsanschluss (9) zu übertragen. Ferner werden ein Verfahren zum Sammeln und Weiterleiten analoger Signale und eine Verwendung des Kabeladapters vorgeschlagen.

## Beschreibung

Die vorliegende Erfindung betrifft einen Kabeladapter zum Sammeln und Weiterleiten analoger Signale von einer Mehrzahl von Sensoren in einem Kraftfahrzeug, insbesondere von Bremsbelagsverschleißsensoren einer Nutzfahrzeugscheibenbremse. Die Erfindung betrifft ferner ein Verfahren zum Sammeln und Weiterleiten analoger Signale von einer Mehrzahl von Sensoren in einem Kraftfahrzeug, insbesondere von Bremsbelagsverschleißsensoren einer Nutzfahrzeugscheibenbremse. Ferner betrifft die Erfindung die Verwendung eines Kabeladapters, um analoge Signalströme mehrerer Sensoren in einem Kraftfahrzeug, insbesondere Bremsbelagsverschleißsensoren einer Nutzfahrzeugscheibenbremse zu sammeln und weiterzuleiten.

Kraftfahrzeuge sind in den letzten Jahrzehnten zu sehr komplexen Erzeugnissen herangereift, die eine Vielzahl mechanischer und elektronischer Komponenten zu einem Gesamtsystem verbinden. Viele Aspekte im Betrieb eines Kraftfahrzeugs, insbesondere auch eines Nutzkraftfahrzeugs, werden von Sensoren überwacht und/oder gesteuert. Diese Sensoren generieren hierbei in der Regel Signalströme, die über Datenleitungen zu einer oder mehreren elektronischen Steuereinheiten einer Fahrzeugelektronik übertragen werden und dort abgespeichert, weiterverarbeitet oder ausgelesen werden.

Der Aufwand, sämtliche Sensoren eines Fahrzeugs mit den entsprechenden Fahrzeugelektronik-Bestandteilen signalleitend zu verknüpfen, ist beträchtlich, und die Länge und Komplexität der hierfür notwendigen Kabelbäume innerhalb des Fahrzeugs ebenso.

Die Fahrzeughersteller verwenden zur Kommunikation mit den im Fahrzeug vorhandenen Bauteilen der Fahrzeugelektronik bestimmte Datenleitungen und Datenschnittstellen, an welche dann die Sensoren von Peripheriegeräten und Funktionsbaugruppen des Kraftfahrzeugs angeschlossen werden müssen. Ein Beispiel für solche Funktionsbaugruppen sind beispielsweise die Bremsen des Kraftfahrzeugs, insbesondere Scheibenbremsen. Scheibenbremsen weisen beispielsweise einen Bremsbelagsverschleißsensor auf, der ein kontinuierliches analoges Signal generiert, welches von einer Fahrzeugelektronik auf den Verschleißzustand der Bremsbeläge hin ausgewertet werden kann. Abhängig vom Bremsenhersteller weisen die Bremsen aber nicht nur einen Sensor, sondern teilweise auch mehr als einen Sensor auf. Wenn also eine Bremse mit mehr als einem Sensor an ein Kraftfahrzeug signaltechnisch angebunden werden soll, war es im Stand der Technik für solche Systeme in der Vergangenheit notwendig, für den zusätzlich vorhandenen Sensor eine zusätzliche Signalleitung zu verlegen, was einen beträchtlichen Installationsaufwand nach sich zog.

Es ist daher angestrebt worden, den Stand der Technik dahingehend zu verbessern, dass die im Fahrzeug vorhandene Schnittstellenarchitektur, insbesondere die im Fahrzeug vorhandenen Datenleitungen, die zu der jeweiligen Fahrzeugelektronik hinführen, für die flexible Verwendung von Funktionsbaugruppen mit einem oder mehreren Sensoren genutzt werden kann, ohne zusätzliche Datenleitungen verlegen zu müssen.

Der Erfindung lag folglich die Aufgabe zugrunde, die Flexibilität der Nutzung in Datenleitungen zur Fahrzeugelektronik hin in einem Kraftfahrzeug, insbesondere Nutzkraftfahrzeug zu erhöhen. Insbesondere lag der Erfindung ferner die Aufgabe zugrunde, die Signale mehrerer Sensoren zu einer Fahrzeugelektronik übertragen zu können, und hierbei den notwendigen Installationsaufwand für Kabelleitungen so gering wie möglich zu halten.

Die Erfindung löst die ihr zugrundeliegende Aufgabe, indem sie einen Kabeladapter zum Sammeln und Weiterleiten analoger Signale von einer Mehrzahl von Sensoren in einem Kraftfahrzeug, insbesondere Bremsbelagsverschleißsensoren einer Nutzfahrzeugscheibenbremse, vorschlägt, wobei der Kabeladapter aufweist:
- einen ersten Signaleingangsanschluss zum Verbinden des Kabeladapters mit einem ersten Sensor und zum Empfangen eines ersten Signalstroms,
- einen zweiten Signaleingangsanschluss zum Verbinden des Kabeladapters mit einem zweiten Sensor und zum Empfangen eines zweiten Signalstroms,
- einen signalleitend mit den Signaleingangsanschlüssen verbundenen Signalausgangsanschluss zum Verbinden des Kabeladapters mittels einer Leitung mit einer elektronischen Steuereinheit des Kraftfahrzeugs, wobei der Kabeladapter eine Schaltelektronik aufweist, die dazu eingerichtet ist, in einem vorbestimmten Rhythmus die ersten und zweiten Signalströme, insbesondere alternierend, an den Signalausgangsanschluss zu übertragen.

Bei der mit dem Signalausgangsanschluss verbundenen Leitung handelt es sich insbesondere um eine im Fahrzeug bereits installierte Datenleitung mit einer vordefinierten Datenschnittstelle. Die Datenschnittstelle wird sich in der Praxis kundenspezifisch von Fall zu Fall unterscheiden, und der Kabeladapter wird jeweils derart an die Datenschnittstelle angepasst sein, dass er mit ihr verbindbar ist. Eine besonders bevorzugte Datenschnittstelle zum Anschluss an den Signalausgangsanschluss des Kabeladapters ist beispielsweise eine analoge 0-5 V - Schnittstelle.

Die Erfindung macht sich die Erkenntnis zunutze, dass es durch eine Rhythmisierung der Übertragung der mehreren eingehenden Signalströme mit sehr geringem baulichen und sehr geringem schaltungstechnischen Aufwand möglich ist, die Sensorsignale insbesondere der Bremsbelagsverschleißsensoren einer Nutzfahrzeugscheibenbremse, an die elektronische Steuereinheit des Fahrzeugs zu übertragen. Dies basiert vor allem auf dem Gedanken, dass die Belagsverschleißsensoren keine Überwachung in Echtzeit gewährleisten müssen, weil der Verschleiß der Bremsbeläge graduell und über längere Zeiträume auftritt. Bei Erreichen eines bestimmten Verschleißwertes ist es zwar wichtig, dass der Bediener des Kraftfahrzeuges davon erfährt, es ist aber in der Regel nicht ausschlaggebend, das Ereignis, bei dem ein vorbestimmter kritischer Verschleißwert auftritt, auf die Hundertstelsekunde genau mitgeteilt wird. Deshalb ist es unschädlich, wenn der Kabeladapter mit seiner Schaltelektronik die eingehenden Signalströme lediglich alternierend, und somit gewissermaßen verlustbehaftet, in vorbestimmten Zeitabständen an den Signalausgangsanschluss und somit an die elektronische Steuereinheit überträgt.

Die Erfindung wird vorteilhaft weitergebildet, indem der Signalausgangsanschluss eine vorbestimmte Bandbreite aufweist, und die Schaltelektronik dazu eingerichtet ist, die eingehenden ersten und zweiten Signalströme zu codieren und als codierten Ausgangssignalstrom zu übertragen. Besonders bevorzugt ist natürlich dann die elektronische Steuereinheit des Kraftfahrzeugs dazu eingerichtet, den codierten Ausgangssignalstrom zu decodieren. Unter dem Codieren der Signalströme wird vorliegend verstanden, dass die Schaltelektronik die eingehenden Signalströme in eine andere Signalform umsetzen kann, ohne aber dem wesentlichen Signalinhalt zu interpretieren, oder gar zu manipulieren. Beispiele einer nicht-manipulativen Umsetzung sind beispielsweise das positive oder negative Verstärken der eingehenden Signalströme, das Transponieren der Signalströme in vorbestimmte Bandbreiten, das Hinzufügen von Identifikatoren vor oder nach in Pakete unterteilten Signalströmen, oder das Umwandeln der Signalströme von einem analogen Signal in ein digitales Signal. Dies wird jeweils in den nachfolgenden Ausführungsbeispielen erläutert.

So ist die Schaltelektronik in einem bevorzugten Ausführungsbeispiel dazu eingerichtet, den eingehenden ersten Signalstrom in ein erstes vorbestimmtes Signalband mit einer Bandbreite zu codieren, welche schmaler als die Bandbreite des Signalausgangsanschlusses ist, den eingehenden zweiten Signalstrom in ein zweites vorbestimmtes Signalband mit einer Bandbreite zu codieren, welche schmaler als die Bandbreite des Signalausgangsanschlusses ist, und die in die Signalbänder codierten Signalströme als codierten Ausgangssignalstrom an den Signalausgangsanschluss zu übertragen. Hierdurch können als die unterschiedlichen eingehenden Signalströme von der Schaltelektronik jeweils in eine charakteristische Bandbreite verschoben werden, die ausgangsseitig von einer signalleitend mit dem Signalausgangsanschluss verbundenen elektronischen Steuereinheit erkannt werden.

Vorzugsweise ist die elektronische Steuereinheit dann so programmiert, dass sie automatisch diejenigen Signalinformationen, welche in den ersten vorbestimmten Signalband liegen, einem ersten Sensor zuzuordnen und diejenigen Signalanteile, die in dem zweiten Signalband liegen, dem zweiten Sensor zuzuordnen. Je höher die Anzahl der am Kabeladapter angeschlossenen Sensoren ist, desto geringer ist die für jeden Sensor zur Verfügung stehende Bandbreite. Jedoch macht sich hier vorteilhaft bemerkbar, dass in der Regel nicht sämtliche Sensoren Signale übertragen, die die gesamte Bandbreite des Signalausgangsanschlusses beziehungsweise der mit ihm verbundenen Leitung erfordern. Einer oder mehrere Sensoren unter der Anzahl von Sensoren werden in der Regel so genannte Schwarz/Weiß-Sensoren sein, die also nur ein 1/0-Signal für das Vorliegen oder Nichtvorliegen eines bestimmten Zustandes kommunizieren. Solche Sensoren werden vorzugsweise einem engeren Signalband zugewiesen als Sensoren, die komplexere Signalabläufe generieren.

In einer weiteren bevorzugten Ausführungsform ist die Summe der Bandbreiten der ersten und zweiten (kodierten) Signalbänder geringer als die Bandbreite des Signalausgangsanschlusses, und vorzugsweise sind die ersten und zweiten Signalbänder voneinander beabstandet. Besonders bevorzugt ist zwischen benachbarten Signalbändern jeweils ein Sicherheitsabstand, also ein Signalband, welches unbelegt bleibt, vorgesehen. Hierdurch wird verhindert, dass die am Signalausgangsanschluss anliegenden Signale von der nachgeschalteten elektronischen Steuereinheit falsch zugeordnet werden.

In einer alternativen bevorzugten Ausführungsform weist der Signalausgangsanschluss eine vorbestimmte Bandbreite auf, die Schaltelektronik ist hier aber dazu eingerichtet, die eingehenden Signalströme jeweils in ihrer vollen Bandbreite an den Signalausgangsanschluss zu übertragen, oder, falls die Bandbreite der eingehenden Signalströme höher als die Bandbreite des Signalausgangsanschlusses ist, die eingehenden Signalströme in ein Signalband mit der vorbestimmten Bandbreite zu kodieren, insbesondere zu verstärken (positiv oder negativ), und die eingehenden Signalströme in der vorbestimmten Bandbreite zu übertragen.

Weiter vorzugsweise ist die Schaltelektronik dazu eingerichtet, jeweils bei einem Wechsel von der Übertragung eines Signalstroms zum nächsten Signalstrom ein Identifikationssignal an den Signalausgangsanschluss zu übertragen, das repräsentativ für den dann folgenden Signalstrom ist. Hierdurch wird es der nachgeschalteten elektronischen Steuereinheit erleichtert, die alternierend übertragenen Signale der ersten und zweiten Sensoren korrekt zuzuordnen.

Das Identifikationssignal kann hierbei vorzugsweise in Form einer vorbestimmten, für den jeweiligen Signalstrom charakteristischen Anzahl von Spannungspulsen vorliegen.

In einer weiteren bevorzugten Ausführungsform sind die Signaleingangsanschlüsse jeweils Spannungssignalanschlüsse, und weisen vorzugsweise eine Bandbreite in einem Bereich von 0 V bis 12 V auf, weiter vorzugsweise in einem Bereich von 0 V bis 5 V.

Weiter vorzugsweise ist der Signalausgangsanschluss ebenfalls ein analoger Spannungssignalanschluss, und vorzugsweise in einer Bandbreite in einem Bereich von 0 V bis 12 V ausgebildet, weiter vorzugsweise in einem Bereich von 0 V bis 5 V. Hierbei handelt es sich um die derzeit für die Kommunikation mit Belagsverschleißsensoren von Kraftfahrzeugscheibenbremsen oder wahlweise auch Bruchsensoren etc. meist verwendete Datenschnittstelle, die im Kraftfahrzeug vielfach bereits vorhanden ist. Der erfindungsgemäße Kabeladapter erlaubt in dieser Ausführungsform besonders vorbildlich die Kommunikation mehrerer analoger Sensoren mit dieser einen analogen Schnittstelle, ohne die Notwendigkeit zusätzlicher Kabelinstallationen, und ohne weitere Signalleingänge an der Systemseitigen Eingangselektronik belegen zu müssen.

Alternativ zu dem vorstehend skizzierten rein analogen Anwendungsfall ist aber auch in bevorzugten Ausführungsformen vorgesehen, dass der Signalausgangsanschluss ein digitaler Signalausgangsanschluss ist, und die Schaltelektronik dazu eingerichtet ist, die eingehenden Signalströme in ein Signal einer digitalen Datenschnittstelle zu kodieren. Die digitale Datenschnittstelle kann beispielsweise als Punkt-zu-Punkt-Schnittstelle oder als Bus-Schnittstelle ausgebildet sein, insbesondere ausgewählt aus der Liste bestehend aus:
Pulse Width Modulation (PWM),
Single Edge Nibble Transmission (SENT),
Peripheral Sensor Interface 5 (PSI5), oder
Feldbus, insbesondere Local Interconnect Network (LIN) oder Controller Area Network (CAN).

Die Erfindung wurde vorstehend in einem ersten Aspekt unter Bezugnahme auf den erfindungsgemäßen Kabeladapter beschrieben. In einem weiteren Aspekt betrifft die Erfindung, wie eingangs erwähnt, allerdings auch ein Verfahren zum Sammeln und Weiterleiten analoger Signale von einer Mehrzahl von Sensoren in einem Kraftfahrzeug. Die Erfindung löst die eingangs bezeichnete Aufgabe, indem das Verfahren die Schritte umfasst:
- Empfangen eines ersten Signalstroms von einem ersten Sensor,
- Empfangen eines zweiten Signalstroms von einem zweiten Sensor, insbesondere mittels eines über jeweilige Signaleingangsanschlüsse mit den Sensoren verbundenen Kabeladapters, und
- Alternierendes Übertragen der ersten und zweiten Signalströme in einem vorbestimmten Rhythmus, insbesondere mittels eines Signalausgangsanschlusses des Kabeladapters.

Das erfindungsgemäße Verfahren macht sich in vollem Umfang die Vorteile und bevorzugten Ausführungsformen des im ersten Aspekt beschriebenen Kabeladapters zu eigen. Die bevorzugten Ausführungsformen des Kabeladapters sind daher zugleich bevorzugte Ausführungsformen des erfindungsgemäßen Verfahrens.

Das Verfahren wird im Übrigen vorteilhaft weitergebildet, indem die Übertragung der ersten und zweiten Signalströme mittels des Signalausgangsanschlusses in einer vorbestimmten Bandbreite erfolgt, und das Verfahren umfasst:
- Codieren des eingehenden ersten Signalstroms, und
- Codieren des eingehenden zweiten Signalstroms.

Vorzugsweise umfasst das Codieren:
- Codieren des eingehenden ersten Signalstroms in ein erstes vorbestimmtes Signalband mit einer Bandbreite, welche schmaler als die Bandbreite des Signalausgangsschlusses ist,
- Codieren des eingehenden zweiten Signalstroms in ein zweites vorbestimmtes Signalband mit einer Bandbreite, welche schmaler als die Bandbreite des Signalausgangsschlusses ist, und
- Übertragen der in die Signalbänder kodierten Signalströme an den Signalausgangsanschluss zu übertragen,
wobei vorzugsweise die Summe der Bandbreiten der Signalbänder geringer als die Bandbreite des Signalausgangsanschlusses ist, und weiter vorzugsweise die ersten und zweiten Signalbänder voneinander beabstandet sind.

Weiter vorzugsweise erfolgt die Übertragung mittels des Signalausgangsanschlusses in einer vorbestimmten Bandbreite, und das Verfahren umfasst:
a) Übertragen der eingehenden Signalströme jeweils in ihrer vollen Bandbreite an den Signalausgangsanschluss zu übertragen, oder
b) Codieren der eingehenden Signalströme jeweils in ein Signalband mit der vorbestimmten Bandbreite, und Übertragen der eingehenden Signalströme in der vorbestimmten Bandbreite.

Vorzugsweise umfasst das Verfahren dann ferner das Übertragen, jeweils bei einem Wechsel von der Übertragung eines Signalstroms zum nächsten Signalstrom, eines Identifikationssignals an den Signalausgangsanschluss, dass repräsentativ für den dann folgenden Signalstrom misst, und dann weiter vorzugsweise das Identifikationssignal in Form einer vorbestimmten, für den jeweiligen Signalstrom charakteristischen Anzahl von Spannungsimpulsen vorliegt.

Weiter vorzugsweise sind die Signaleingangsanschlüsse jeweils Spannungssignalanschlüsse, und weisen vorzugsweise eine Bandbreite in einem Bereich von 0 V bis 12 V auf, weiter vorzugsweise in einem Bereich von 0 V bis 5 V, und der Signalausgangsanschluss ist entweder a) ein analoger Spannungssignalanschluss und weist vorzugsweise eine Bandbreite von 0 V bis 12 V auf, weiter vorzugsweise in einem Bereich von 0 V bis 5 V, oder b) ein digitaler Signalanschluss, und das Codieren umfasst ferner: Codieren der eingehenden Signalströme in ein Signal einer digitalen Datenschnittstelle, welche vorzugsweise als Punkt-zu-Punkt-Schnittstelle oder als Bus-Schnittstelle, vorzugsweise serielle Bus-Schnittstelle, insbesondere ausgewählt aus der Liste bestehend aus:
Pulse Width Modulation (PWM)
Single Edge Nibble Transmission (SENT),
Peripheral Sensor Interface 5 (PSI5), oder
Feldbus, insbesondere Local Interconnect Network (LIN) oder Controller Area Network (CAN).

Die Erfindung betrifft in einem weiteren Aspekt die Verwendung eines Kabeladapters, um analoge Signalströme mehrerer Sensoren in einem Kraftfahrzeug, insbesondere Bremsbelagsverschleißsensoren einer Nutzfahrzeugscheibenbremse zu sammeln und weiterzuleiten, wobei
- ein erster Sensor mit einem ersten Signaleingangsanschluss des Kabeladapters zum Empfang eines ersten analogen Signalstroms verbunden wird,
- ein zweiter Sensor mit einem zweiten Signaleingangsanschluss des Kabeladapters zum Empfang eines zweiten analogen Signalstroms verbunden wird,
   eine elektronische Steuereinheit des Kraftfahrzeugs mittels einer Leitung signalleitend mit einem mit den Signaleingangsanschlüssen verbundenen Signalausgangsanschluss verbunden wird, und
- eine Schaltelektronik des Kabeladapters in einem vorbestimmten Rhythmus die ersten und zweiten Signalströme, insbesondere alternierend, an den Signalausgangsanschluss überträgt.

Die erfindungsgemäße Verwendung macht sich in vollem Umfang die Vorteile und bevorzugten Ausführungsformen des erfindungsgemäßen Verfahrens und des erfindungsgemäßen Kabeladapters zu eigen, weswegen zur Vermeidung von Wiederholungen auf die obigen Ausführungen verwiesen wird. Die bevorzugten Ausführungsformen des erfindungsgemäßen Kabeladapters und des erfindungsgemäßen Verfahrens sind gleich bevorzugte Ausführungsformen der erfindungsgemäßen Verwendung.

Die Erfindung wird im Folgenden unter Bezugnahme auf die beigefügten Figuren anhand bevorzugter Ausführungsbeispiele näher beschrieben. Hierbei zeigen:
- Fig. 1:: einen Kabeladapter gemäß einem bevorzugten Ausführungsbeispiel,
- Fig. 2:: eine diagrammatische Darstellung des Betriebs des Kabeladapters in einer ersten bevorzugten Variante, und
- Fig. 3:: eine diagrammatische Darstellung des Betriebs des erfindungsgemäßen Kabeladapters in einer zweiten bevorzugten Variante.

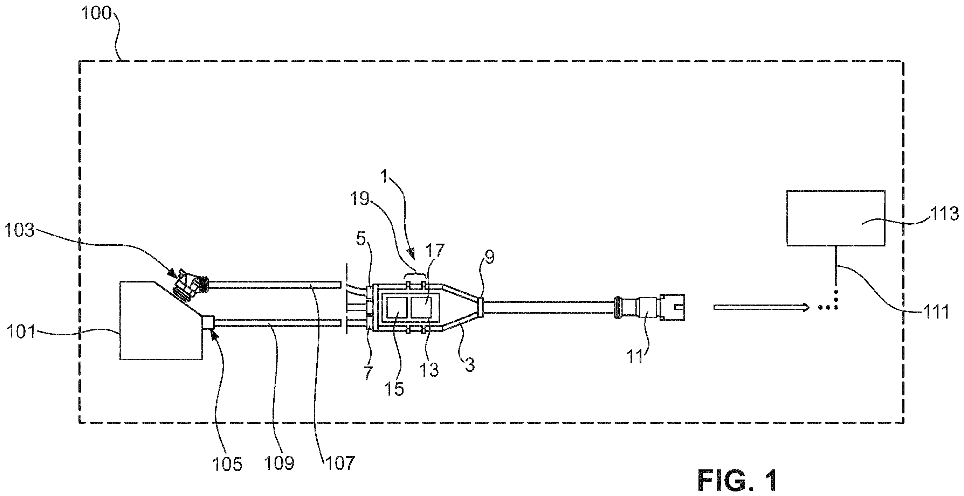

Figur 1 zeigt schematisch ein Kraftfahrzeug 100. Das Kraftfahrzeug 100 ist beispielsweise ein Nutzkraftfahrzeug. Das Kraftfahrzeug 100 weist eine Bremse 101 auf, an der ein erster Sensor 103 und ein zweiter Sensor 105 angeordnet sind. Die Sensoren 103, 105 sind beispielsweise Verschleißsensoren, insbesondere Bestandteile eines modularen Bremsbelagsverschleißsensors. Die Sensoren 103, 105 sind mittels entsprechender Kabelleitungen 107, 109 mit einem Kabeladapter 1 verbunden. Der Kabeladapter 1 weist einen ersten Signaleingangsanschluss 5 auf, mit dem der erste Sensor 103 verbunden ist, und einen zweiten Signaleingangsanschluss 7, mit dem der zweite Sensor 105 verbunden ist.

Der Kabeladapter 1 weist ferner einen Signalausgangsanschluss 9 auf, der dazu eingerichtet ist, beispielsweise mittels eines Steckverbinders 11, über eine Kabelleitung 111 mit einer elektronischen Steuereinheit 113 des Fahrzeugs 100 verbunden zu werden, beziehungsweise verbunden ist.

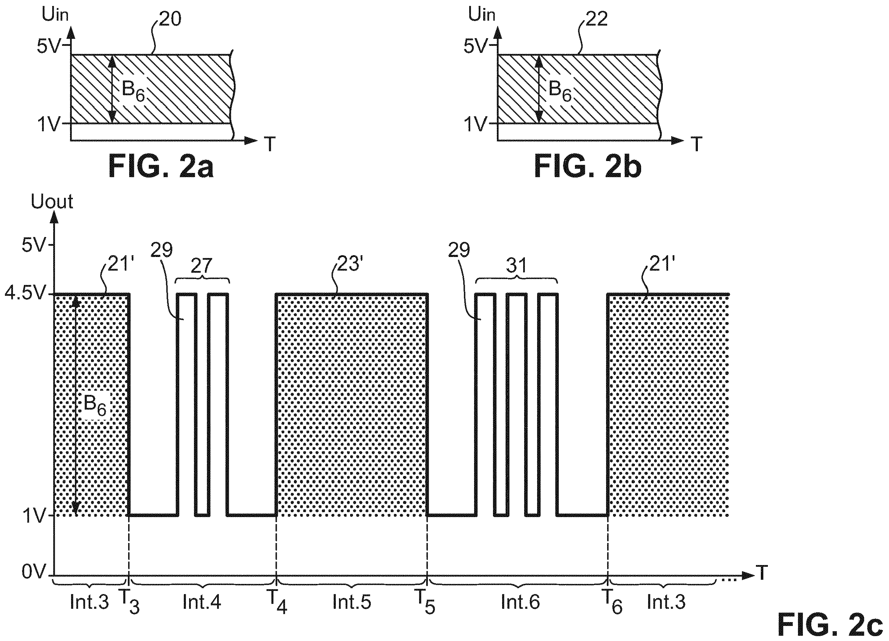

Der Kabeladapter 1 weist eine Schaltelektronik 13 auf. Die Schaltelektronik 13 ist dazu eingerichtet, vorne an dem ersten Sensor 103 einen ersten Signalstrom 20 zu empfangen (vgl. Figuren 2a bis 3c), und von dem zweiten Sensor 105 einen zweiten Signalstrom 22 zu empfangen (vgl. Figuren 2a bis 3c). Ferner ist die Schaltelektronik 13 dazu eingerichtet, in einem vorbestimmten Rhythmus die ersten und zweiten Signalströme 20, 22 alternierend an den Signalausgangsanschluss 9 zu übertragen. Die Schaltelektronik 13 ist vorzugsweise als Mikroprozessor ausgebildet, und umfasst Prozessormittel 15 und Speichermittel 17, auf denen ein Programm zum Ausführen der vorstehend beschriebenen Rhythmisierung und Übertragung zu gewährleisten.

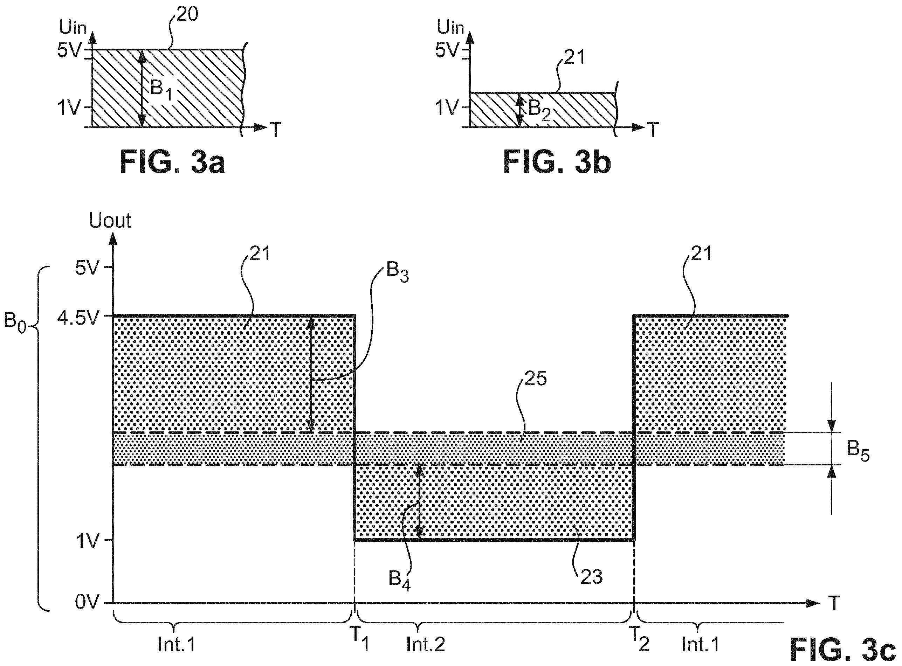

Die erfindungsgemäße Funktionsweise des Kabeladapters 1 und der Schaltelektronik 13 ist exemplarisch an einem ersten Ausführungsbeispiel gemäß Figuren 2a bis c und einem zweiten Ausführungsbeispiel gemäß Figuren 3a bis c erläutert.

Die Schaltelektronik 13 führt im Ausführungsbeispiel gemäß den Figuren 2a bis c eine Codierung aus, die in diesem Fall darin besteht, dass sie den ersten Ausgangssignalstrom 21' mit im Wesentlichen derselben Bandbreite B6 überträgt, wie derjenigen des eingehenden Signalstroms 21.

Der Einfachheit halber wird für dieses Ausführungsbeispiel angenommen, dass die eingehenden Signalströme 20, 22 der ersten und zweiten Sensoren 103, 105 die gleiche Bandbreite B6 aufweisen. Das Prinzip ließe sich aber genauso gut mit voneinander unterschiedlichen Bandbreiten anwenden.

Nach dem Verstreichen des hierfür vorgesehenen Zeitintervalls Int.3 nimmt die Schaltelektronik 13 zum Zeitpunkt T₃ einen Übertragungswechsel vor. Bevor aber der zweite Ausgangssignalstrom 23', wiederum mit der Bandbreite B6, an den Signalausgangsanschluss 9 übertragen wird, überträgt die Schaltelektronik 13 während eines Zeitintervalls Int.4 bis zum Zeitpunkt T₄ eine erste Anzahl 27 von Umschaltpulsen 29, beispielsweise zwei Umschaltpulse 29, die für das darauffolgende Signal, also den zweiten Ausgangssignalstrom 23', repräsentativ ist. Die Signalströme werden in diesem Ausführungsbeispiel mittels Voranstellen eines jeweiligen Identifikators, d.h. Identifikationselements, codiert. Im Anschluss das Einfügen des Identifikators in Form der Umschaltpulse 29 überträgt die Schaltelektronik für ein Zeitintervall Int.5 bis zum Zeitpunkt T₅ den zweiten ausgehenden Signalstrom 23'. Zum Zeitpunkt T₅ findet ein erneuter Übertragungswechsel statt. Bevor dann allerdings wiederum der erste ausgehende Signalstrom 21' übertragen wird, überträgt die Schaltelektronik 13 während eines weiteren Intervalls Int.6 bis zum Zeitpunkt T₆ eine zweite Anzahl 31 von Umschaltpulsen 29, die charakteristisch für den ersten Ausgangssignalstrom 21' sind. Die Intervalle Int.4 und Int.6 sind im gezeigten Ausführungsbeispiel im Wesentlichen gleichlang, ebenso wie die Intervalle Int.3 und Int.5, in denen die Signalströme 21', 23' übertragen werden.

Anwendungsspezifisch können die Zeitintervalle aber auch voneinander abweichend gewählt werden.

Der Aufwand auf Seiten der elektronischen Steuereinheit 113 des Kraftfahrzeugs 100 ist in diesem Ausführungsbeispiel erfreulich niedrig. Über eine Erkennung der Anzahl Umschaltpulse 27, 31 ist eine Erkennung des jeweils darauffolgenden Signalstroms 21', 23' und damit die Zuordnung zu dem ersten Sensor 103 beziehungsweise zweiten Sensor 105 jederzeit leicht verwirklicht.

Alternativ oder zusätzlich zu einer Codierung mittels Identifikatoren, kann, wie sich aus den Figuren 3a bis c ergibt, auch eine Bandbreitencodierung vorgenommen werden. Hierfür wird der Schaltelektronik 13 beziehungsweise dem ersten Signaleingangsanschluss 5 ein erster Signalstrom 20 zugeführt, und dem zweiten Signaleingangsanschluss 7 wird ein zweiter Signalstrom 22 zugeführt. Die Schaltelektronik 13 codiert den ersten eingehenden Signalstrom 20 in einen ersten codierten Ausgangssignalstrom 21 mit einer Bandbreite B3, die geringer ist als die Bandbreite B1 des ersten eingehenden Signalstroms 20. In ähnlicher Weise codiert die Schaltelektronik 13 den zweiten eingehenden Signalstrom 22, der die Bandbreite B2 aufweist, in einen zweiten codierten Ausgangssignalstrom 23 mit einer Bandbreite B4, die geringer ist oder gleich der Bandbreite B2. Die Summe der Bandbreiten B3, B4 der beiden codierten Ausgangssignalströme 21, 23 ist geringer als eine gesamte mögliche Bandbreite B0 am Signalausgangsanschluss 9, so dass es möglich ist, einen Sicherheitsbereich 25 an ungenutzter Bandbreite zwischen den von den beiden codierten Ausgangssignalströmen 21, 23 eingenommenen Bandbreiten B3, B4 vorzusehen. Der Sicherheitsbereich 25 hat eine Bandbreite B5 von beispielsweise 0,5 V. Auf diese Weise wird es möglich, mittels der Schaltelektronik 13 die beiden eingehenden Signalströme 20, 22 alternierend an den Signalausgangsanschluss 9 zu übertragen. Zunächst wird für ein erstens Intervall Int.1 bis zum Zeitpunkt T₁ der erste codierte Ausgangssignalstrom 21 übertragen, und sodann für ein zweites Intervall Int.2 bis zum Zeitpunkt T₂ der zweite codierte Ausgangssignalstrom 23, bevor wiederum der erste codierte Ausgangssignalstrom 21 an den Signalausgangsanschluss 9 übertragen wird.

Im in Figur 3a-c gezeigten Ausführungsbeispiel sind die Zeitabstände Int.1 und Int.2 in etwa gleich groß. Sie könnten aber auch unterschiedlich groß sein, je nachdem, in welchen Zeitabständen es gewünscht oder notwendig ist, der elektronischen Steuereinheit 113 des Fahrzeugs 100 entsprechende Statusinformationen der Sensoren 103, 105 zuzuspielen. Der programmiertechnische Aufwand für die elektronische Steuereinheit 113, der es ermöglicht, den codierten Ausgangssignalstrom 21, 23 zu decodieren und die zu den jeweiligen Sensoren 103, 105 gehörigen Signalströme zu identifizieren, ist im Ausführungsbeispiel erfreulich gering. Die Erkennung des ersten oder zweiten codierten Ausgangssignalstroms 21, 23 kann unmittelbar anhand der jeweils für den Signalstrom 21, 23 charakteristischen Bandbreiten B3, B4 erfolgen.

Falls notwendig, kann eine Decodierung in die ursprüngliche Bandbreite B1, B2 vorgenommen werden.

### Bezugszeichenliste

- 1: Kabeladapter
- 5: erster Signaleingangsanschluss
- 7: zweiter Signaleingangsanschluss
- 9: Signalausgangsanschluss
- 11: Steckverbinder
- 13: Schaltelektronik
- 15: Prozessormittel
- 17: Speichermittel
- 20: erster eingehender Signalstrom
- 21, 21': erster Ausgangssignalstrom
- 22: zweiter eingehender Signalstrom
- 23, 23': zweiter Ausgangssignalstrom
- 25: Sicherheitsbereich
- 27: Anzahl
- 29,31: Umschaltpulse

- 100: Kraftfahrzeug
- 101: Bremse
- 103: erster Sensor
- 105: zweiter Sensor
- 107, 109: Kabelleitungen
- 111: Kabelleitung
- 113: Steuereinheit

- B0, B1, B2, B3, B4, B5 B6: Bandbreite

- Int.1 - Int. 6: Intervalle
- T₁ - T₆: Zeitpunkte

## Patentansprüche

1. Kabeladapter (1) zum Sammeln und Weiterleiten analoger Signale von einer Mehrzahl von Sensoren (103, 105) in einem Kraftfahrzeug (100), insbesondere Bremsbelagsverschleißsensoren einer Nutzfahrzeugscheibenbremse, mit
einem ersten Signaleingangsanschluss (5) zum Verbinden des Kabeladapters (1) mit einem ersten Sensor (103) und zum Empfang eines ersten Signalstroms (20),
einem zweiten Signaleingangsanschluss (7) zum Verbinden des Kabeladapters (1) mit einem zweiten Sensor (105) und zum Empfang eines zweiten Signalstroms (22),
einem signalleitend mit den Signaleingangsanschlüssen verbundenen Signalausgangsanschluss (9) zum Verbinden des Kabeladapters (1) mittels einer Leitung (111) mit einer elektronischen Steuereinheit (113) des Kraftfahrzeugs (100), wobei
der Kabeladapter (1) eine Schaltelektronik (13) aufweist, die dazu eingerichtet ist, in einem vorbestimmten Rhythmus die ersten und zweiten Signalströme (20, 22; 21, 23 ;21', 23'), insbesondere alternierend, an den Signalausgangsanschluss (9) zu übertragen.

2. Kabeladapter (1) nach Anspruch 1,
wobei der Signalausgangsschluss (9) eine vorbestimmte Bandbreite (B₀) aufweist, und die Schaltelektronik (13) dazu eingerichtet ist, die eingehenden ersten und zweiten Signalströme (20, 22) zu kodieren und als kodierten Ausgangssignalstrom (21, 23; 21', 23') zu übertragen.

3. Kabeladapter (1) nach Anspruch 2,
wobei die Schaltelektronik (13) dazu eingerichtet ist, den eingehenden ersten Signalstrom (20) in ein erstes vorbestimmtes Signalband mit einer Bandbreite (B₃) zu kodieren, welche schmaler als die Bandbreite (B₀) des Signalausgangsschlusses (9) ist,
- den eingehenden zweiten Signalstrom (22) in ein zweites vorbestimmtes Signalband mit einer Bandbreite (B₄) zu kodieren, welche schmaler als die Bandbreite (B₀) des Signalausgangsschlusses (9) ist, und
- die in die Signalbänder kodierten Signalströme (21, 23; 21', 23') als kodierten Ausgangssignalstrom an den Signalausgangsanschluss (9) zu übertragen.

4. Kabeladapter (1) nach Anspruch 3,
wobei die Summe der Bandbreiten (B₃, B₄) der ersten und zweiten Signalbänder geringer als die Bandbreite (B₀) des Signalausgangsanschlusses (9) ist, und vorzugsweise die ersten und zweiten Signalbänder voneinander beabstandet sind.

5. Kabeladapter (1) nach Anspruch 1 oder 2,
wobei der Signalausgangsschluss (9) eine vorbestimmte Bandbreite (B₀) aufweist, und die Schaltelektronik (13) dazu eingerichtet ist, die eingehenden Signalströme (20, 22) jeweils in ihrer vollen Bandbreite (B₆) an den Signalausgangsanschluss (9) zu übertragen, oder in ein Signalband mit der vorbestimmten Bandbreite zu kodieren und die eingehenden Signalströme (20, 22) in der vorbestimmten Bandbreite zu übertragen.

6. Kabeladapter (1) nach Anspruch 5,
wobei die Schaltelektronik (9) dazu eingerichtet ist, jeweils bei einem Wechsel von der Übertragung eines Signalstroms (21') zum nächsten Signalstrom (23') ein Identifikationssignal an den Signalausgangsanschluss (9) zu übertragen, das repräsentativ für den dann folgenden Signalstrom ist.

7. Kabeladapter (1) nach Anspruch 6,
wobei das Identifikationssignal in Form einer vorbestimmten, für den jeweiligen Signalstrom charakteristischen Anzahl (27, 31) von Spannungspulsen (29) vorliegt.

8. Kabeladapter (1) nach einem der vorstehenden Ansprüche,
wobei die Signaleingangsanschlüsse (9) jeweils Spannungssignalanschlüsse sind, und vorzugsweise eine Bandbreite in einem Bereich von 0 V bis 12 V aufweisen, weiter vorzugsweise in einem Bereich von 0 V bis 5 V aufweist.

9. Kabeladapter (1) nach Anspruch 8,
wobei der Signalausgangsanschluss (9) ein analoger Spannungssignalanschluss ist, und vorzugsweise eine Bandbreite in einem Bereich von 0 V bis 12 V aufweist, weiter vorzugsweise in einem Bereich von 0 V bis 5 V aufweist.

10. Kabeladapter (1) nach einem der Ansprüche 1 bis 8,
wobei der Signalausgangsanschluss (9) ein digitaler Signalausgangsanschluss ist, und die Schaltelektronik dazu eingerichtet ist, die eingehenden Signalströme (20,22) in ein Signal einer digitalen Datenschnittstelle zu kodieren, welche vorzugsweise als Punkt-zu-Punkt-Schnittstelle oder als Bus-Schnittstelle, vorzugsweise serielle Bus-Schnittstelle, ausgebildet ist.

11. Kabeladapter (1) nach Anspruch 10,
wobei die digitale Datenschnittstelle ausgewählt ist aus der Liste bestehend aus:
Pulse Width Modulation (PWM),
Single Edge Nibble Transmission (SENT),
Peripheral Sensor Interface 5 (PSI5), oder
Feldbus, insbesondere Local Interconnect Network (LIN) oder Controller Area Network (CAN).

12. Verfahren zum Sammeln und Weiterleiten analoger Signale von einer Mehrzahl von Sensoren (103, 105) in einem Kraftfahrzeug (100), insbesondere Bremsbelagsverschleißsensoren einer Nutzfahrzeugscheibenbremse, umfassend die Schritte:
- Empfangen eines ersten Signalstroms (20) von einem ersten Sensor (103),
- Empfangen eines zweiten Signalstroms (22) von einem zweiten Sensor (105), insbesondere mittels eines über jeweilige Signaleingangsanschlüsse (5, 7) mit den Sensoren (103, 105) verbundenen Kabeladapters (1), und
- Alternierendes Übertragen der ersten und zweiten Signalströme (20, 22; 21, 23; 21', 23') in einem vorbestimmten Rhythmus, insbesondere mittels eines Signalausgangsanschlusses (9) des Kabeladapters (1).

13. Verfahren nach Anspruch 12,
wobei die Übertragung mittels des Signalausgangsschlusses (9) in einer vorbestimmten Bandbreite (B₀) erfolgt, und das Verfahren umfasst:
- Codieren des eingehenden ersten Signalstroms (20), und
- Codieren des eingehenden zweiten Signalstroms (22).

14. Verfahren nach Anspruch 13,
wobei das Codieren umfasst:
- Codieren des eingehenden ersten Signalstroms (20) in ein erstes vorbestimmtes Signalband mit einer Bandbreite (B₃), welche schmaler als die Bandbreite (B₀) des Signalausgangsschlusses (9) ist,
- Codieren des eingehenden zweiten Signalstroms (22) in ein zweites vorbestimmtes Signalband mit einer Bandbreite (B₄), welche schmaler als die Bandbreite (B₀) des Signalausgangsschlusses (9) ist, und
- Übertragen der in die Signalbänder kodierten Signalströme (21, 23; 21' 23') an den Signalausgangsanschluss (9),
wobei vorzugsweise die Summe der Bandbreiten (B₃, B₄) der Signalbänder geringer als die Bandbreite (B₀) des Signalausgangsanschlusses (9) ist, und weiter vorzugsweise die ersten und zweiten Signalbänder voneinander beabstandet sind.

15. Verfahren nach Anspruch 12 oder 13,
wobei die Übertragung mittels des Signalausgangsschlusses (9) in einer vorbestimmten Bandbreite (B₀) erfolgt, und das Verfahren umfasst:
a) Übertragen der eingehenden Signalströme (20, 22) jeweils in ihrer vollen Bandbreite (B₆) an den Signalausgangsanschluss (9) zu übertragen, oder
b) Codieren der eingehenden Signalströme jeweils in ein Signalband mit der vorbestimmten Bandbreite, und Übertragen der eingehenden Signalströme in der vorbestimmten Bandbreite.

16. Verwendung eines Kabeladapters, um analoge Signalströme mehrerer Sensoren (103, 105) in einem Kraftfahrzeug (100), insbesondere Bremsbelagsverschleißsensoren einer Nutzfahrzeugscheibenbremse zu sammeln und weiterleiten, wobei der Kabeladapter nach einem der Ansprüche 1 bis 11 ausgebildet ist.
